# EUROPÄISCHE PATENTANMELDUNG

(11) **EP 1 361 602 A2**
(43) Veröffentlichungstag der Anmeldung: **12.11.2003**
(21) Anmeldenummer: 03009260.5
(22) Anmeldetag: 23.04.2003
(51) Int. Cl.: H01L 21/304, H01L 21/461, B24B 9/06

(54) **Verfahren zur Formgebung eines Randbereichs eines Wafers**

(30) Priorität: 08.05.2002 DE 10220647
(71) Anmelder: Infineon Technologies AG, 81669 München (DE)
(72) Erfinder: Schmidt, Thomas, 9500 Villach (AT)
(74) Vertreter: Patentanwälte Westphal, Mussgnug & Partner

(57) **Zusammenfassung**

Die Erfindung betrifft ein Verfahren zur Formgebung eines Randbereiches eines Wafers mit den Verfahrensschritten:
(a) Ein Wafer mit einer ersten und einer zweiten Oberfläche wird bereitgestellt;
(b) Auf einen inneren Bereich der ersten Oberfläche wird mindestens eine Schicht aufgebracht, so dass zumindest ein Teil eines Randbereiches auf der ersten Oberfläche von der mindestens einen Schicht unbedeckt bleibt;
(c) Der Randbereich des Wafers wird so lange abgetragen, bis sämtliche Randbereiche auf der ersten Oberfläche von der mindestens einen Schicht bedeckt sind;
(d) Der Wafer wird von der zweiten Oberfläche her bis zu einer vorgegebenen Dicke dünn geschliffen.

## Beschreibung

Die Erfindung betrifft ein Verfahren zur Formgebung eines Randbereiches eines Wafers.

In der modernen Halbleitertechnologie, insbesondere bei Leistungshalbleiterbauelementen, wie Leistungs-MOSFETs, IGBTs, Thyristoren und dergleichen, geht die Tendenz hin zu einer Reduzierung der Waferdicke, um dadurch den Einschaltwiderstand R_{DS,ON} des Halbleiterbauelementes zu reduzieren und um damit die Durchlass- und Schaltverluste des Halbleiterbauelementes zu optimieren. Heutige Halbleiterwafer werden daher vor oder während der Herstellung der Leistungshalbleiterbauelemente dünn geschliffen, typischerweise auf eine Dicke von 140µm und weniger.

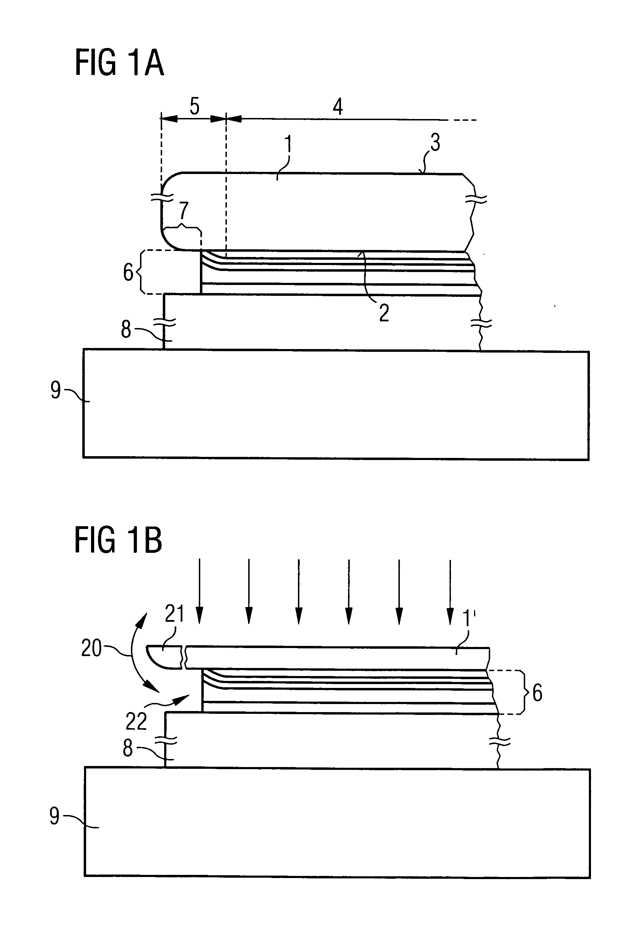

Solche dünnen Wafer sind allerdings aufgrund ihrer verringerten Dicke im Vergleich zu Ihrem Durchmesser sowie aufgrund ihrer mechanischen Eigenschaften sehr schwierig zu handhaben. Insbesondere sehr dünn geschliffene oder geätzte Wafer neigen zu flatternden Rändern sowie Kantenausbrüchen. Besonders gravierend ist dieser Effekt bei ultradünnen Wafern im Bereich von etwa 70 µm. Dieses Problem sei nachfolgend anhand der Teilschnitte (a) und (b) in Figur 1 dargestellt:

Figur 1(a) zeigt einen Wafer 1, auf dessen Oberfläche 2 eine Vielzahl von Schichten 6 aufgebracht sind. Der Wafer 1 ist über eine Folie 8 auf einem Chuck 9 befestigt. Die auf der Oberfläche 2 aufgebrachten Schichten 6 bedecken jedoch den Wafer 1 nicht vollständig, vielmehr ist der Wafer 1 im Randbereich 7 unbedeckt. Diese unbedeckten Randbereiche 7 sind zur Vermeidung von Fertigungsproblemen auch erforderlich.

Zu diesem Zwecke weist der Wafer 1 eine Randentlackung auf, d.h. im unmittelbaren Randbereich 7 an der Waferkante weist der Wafer 1 keinen Fotolack auf. "Randentlackung" oder häufig auch "Edge-Exclusion" genannt ist ein in der Halbleitertechnologie gängiger Begriff und definiert den nicht nutzbaren Bereich am Rand eines Wafers, der durch Ungleichmäßigkeiten der auf den Wafer aufgebrachten Schichten bzw. durch die Entlackung selbst zustande kommt. Diese Randendlackung ist erforderlich, damit der für die Strukturierung erforderliche Fotolack nicht auf die Rückseite 3 des Wafers 1 gelangt. Würde der Wafer 1 in einem solchen Fall auf eine heiße Scheiben (Hot-Plate) zum Ausheizen des Fotolacks gelegt werden, kann der Wafer dort festkleben und nur sehr aufwendig wieder abgelöst werden. Um dies zu vermeiden, müsste die Waferrückseite nach jedem Belackungsprozess gereinigt werden, was bei einer Vielzahl von Strukturierungsschritten sehr aufwendig und somit sehr kostenintensiv wäre. Darüber hinaus besteht grundsätzlich auch das Problem einer Verschmutzung von nachfolgend auf derselben heißen Platte zu bearbeitenden Wafern.

Aufgrund der Notwendigkeit einer Randendlackung ist die Oberfläche 2 des Wafers 1 im Bereich der Randendlackung zwangsläufig auch unbedeckt. Die Forderung jedoch, dass der Wafer 1 in einem Randbereich 7 unbedeckt sein muss, führt aber gerade bei sehr dicken Schichten 6 dazu, dass sich eine mit jeder zusätzlich aufgebrachten Schicht 6 höher werdende Stufe 22 am Rand 7 des Wafers 1 ergibt. Dieses Problem ist besonders gravierend bei Leistungshalbleiterbauelementen, bei denen die aufgebrachten Halbleiterschichten, insbesondere das zur Isolierung dienende Feldoxid sowie die Metallisierungen, besonders dick ausgebildet sind. Beispielsweise weist diese Stufe 22 im Randbereich bei einem heute verwendeten Standard-IGBT- bzw. MOS-Prozess eine Dicke D5 von mehr als 10 µm und eine von der spezifizierten Randentlackung abhängende Breite von mindestens 1 mm auf. Dieser Randbereich 7 des Wafers 1 hängt also gewissermaßen über den aufgebrachten Schichten 6 über. Bei einem Standarddicke aufweisenden Wafer hat dieses Überhängen kaum Auswirkungen auf die Stabilität des Wafers im Randbereich 7. Wird jedoch der Wafer 1 gedünnt, dann beginnt der überhängende Bereich des Wafers 1, der aufgrund der sehr hohen Stufe 22 nur unzureichend von der Klebefolie 8 gestützt wird, beim Schleifen des Wafers 1 zu "flattern". Man spricht hier von einem Flatterrand, was in Figur 1(b) mit Bezugszeichen 20 angedeutet ist. Bei der weiteren Prozessierung solcher dünnen Wafer 1' kann dies zu Rand- oder Kantenausbrüchen 21 führen, was häufig einen Waferausfall zur Folge hat.

Das Problem der Kantenausbrüche wird bislang dadurch umgangen, dass die Wafer nur bis zu einer solchen Dicke dünn geschliffen werden, bei der Randausbrüche bzw. ein Flattern der Randbereiche vermieden wird. Zum anderen wird auch durch eine geeignete Umstellung der Halbleiterprozesse vermieden, dass die mechanisch instabilen Randbereiche von dünn geschliffenen Wafern eine zu große mechanische Belastung, die zu Kantenausbrüchen führen würden, erfahren.

Das bedeutet aber gleichsam, dass zwar das Problem von flatternden Waferrändern bzw. Randausbrüchen durch eine geeignete Wahl der Halbleiterprozesstechnologie umgangen werden kann, jedoch ist dieses Problem bislang nicht vollständig beseitigt und damit noch immer nicht gelöst.

Der vorliegenden Erfindung liegt daher die Aufgabe zugrunde, flatternde Ränder bzw. Randausbrüche während oder nach dem Dünnen eines Wafers weitestgehend zu vermeiden.

Erfindungsgemäß wird diese Aufgabe durch ein Verfahren mit den Merkmalen des Patentanspruchs 1 gelöst. Demgemäß ist ein Verfahren zur Formgebung eines Randbereiches eines Wafers vorgesehen, welches die folgenden Verfahrensschritte aufweist:
(a) Ein Wafer mit einer ersten und einer zweiten Oberfläche wird bereitgestellt;
(b) Auf einen inneren Bereich der ersten Oberfläche wird mindestens eine Schicht aufgebracht, so dass zumindest ein Teil eines Randbereiches auf der ersten Oberfläche von der mindestens einen Schicht unbedeckt bleibt;
(c) Der Randbereich des Wafers wird so lange abgetragen, bis sämtliche Randbereiche auf der ersten Oberfläche von der mindestens einen Schicht bedeckt sind;
(d) Der Wafer wird von der zweiten Oberfläche her bis zu einer vorgegebenen Dicke dünn geschliffen.

Die der vorliegenden Erfindung zugrunde liegende Idee besteht darin, dass durch das Abschleifen der Waferkante der überhängende Randbereich des Wafers für den nachfolgenden Dünnungsprozess vollständig entfernt wird. Dadurch ist es möglich, Wafer trotz der erforderlichen Randentlackung auf sehr geringe Dicken von weniger als 140 µm dünn zu schleifen, ohne dass die Gefahr von Randausbrüchen besteht. Dies verringert Waferausfälle und erhöht die Wirtschaftlichkeit deutlich.

Mit der erfindungsgemäßen Formgestaltung des Randes des Wafers geht natürlich auch eine Reduzierung der effektiven Waferoberfläche einher. Da jedoch der Bereich der Randentlackung und somit der Bereich, der durch die Formgestaltung des Randes abgetragen werden soll, ohnehin keine Halbleiterbauelemente aufweist und aus technischen Gründen ohnehin nicht nutzbar ist, führt das Abschleifen des Randes auch nicht zu einer Verringerung der auf einem Wafer verwendbaren Halbleiterbauelemente, so dass die Ausbeute unverändert bleibt.

Ein weiterer Vorteil des erfindungsgemäßen Verfahrens besteht darin, für die weitere Prozessierung der dünnen Wafer üblicherweise verwendete Halbleiterprozesse sowie die entsprechenden Fertigungsmaschinen verwenden zu können. Diese Prozesse und Maschinen müssen nicht notwendigerweise eigens auf eine behutsame, mechanisch die Oberfläche nicht sonderlich beanspruchende Behandlung optimiert sein. Somit ergibt sich ein zusätzlicher Freiheitsgrad bei der Wahl der geeigneten Herstellungsprozesse.

Das Abtragen bzw. Abschleifen des Randes des Wafers erfolgt vorteilhafterweise mittels eines Schleifsteins, der z. B. als Schleifrad ausgebildet sein kann und um den Rand des Wafers umlaufend ausgebildet ist. Die Schleifvorrichtung kann aber auch anders ausgebildet sein, z. B. als Schleifscheibe oder Bandschleifer. Das Schleifrad weist einen zur Wafermitte gerichteten Vorschub auf. Dadurch wird gewährleistet, dass das Schleifrad ständig Kontakt zur Außenfläche des Waferrandes hat und diesen somit abtragen kann.

Die Waferkante wird heute typischerweise mechanisch mit einem Schleifstein, der unterschiedliche Formen je nach Waferdicke aufweist, so bearbeitet, das eine verrundete Kante entsteht. Dieser Prozess ist vorteilhafterweise vollautomatisiert. Beim Abtragen kann sich entweder die Schleifvorrichtung um den Wafer herumdrehen oder an dem Wafer entlangfahren oder der Wafer kann sich drehen, wobei die Schleifvorrichtung ortsfest ausgeführt ist.

In einer sehr vorteilhaften Ausgestaltung weist das Schleifrad eine zumindest teilweise konkav ausgebildete, d.h. nach außen gewölbte schleifende Oberfläche auf. Dadurch wird sichergestellt, dass die Außenflächen von Waferrand und die die Waferoberfläche bedeckende Schichten nach dem Abtragen des Randes abgerundet und in etwa konvex ausgebildet sind.

Vorteilhafterweise weist der Randbereich des Wafers sowie die darauf aufgebrachte Schicht nach dem Abschleifen bzw. Abtragen eine durchgehende Außenfläche auf, so dass eine stufenförmige, nicht stetige Außenfläche zwischen Wafer und den darauf aufgebrachten Schichten vermieden wird.

Zusätzlich oder alternativ kann die Randabtragung unter Zuhilfenahme eines Lasers mit hoher Laserstrahlleistung und/oder unter Zuhilfenahme eines fokussierten Wasserstrahls mit hoher Wasserstrahlgeschwindigkeit erfolgen. Alternativ kann zur Randabtragung auch ein Polierfilzmittel mit abtragender Eigenschaft verwendet werden. Als Polierfilzmittel kann beispielsweise ein Polierfilz oder eine abtragende Politur vorgesehen sein. Die Randabtragung mittels Lasers- oder focusiertem Wasserstrahl sind alternative Möglichkeiten zu dem Abschleifen, die sich insbesondere dann anbieten, wenn beispielsweise das Abschleifen mit dem Schleifstein nicht mehr funktioniert. Dies kann beispielsweise dann vorkommen, wenn in den abzuschleifenden Schichten Materialen vorhanden sind, die den Stein verkleben bzw. abstumpfen. Hier kann vorteilhafterweise die berührungslose Methode mit Laser oder Hochdruckwasserstrahl sinnvoller und effektiver sein.

Vor dem Dünnschleifen wird der Wafer typischerweise auf einen Chuck aufgelegt und beispielsweise mittels Vakuum fixiert. Besonders vorteilhaft ist es jedoch, wenn statt der Verwendung eines typischerweise verwendeten Vakuumchucks ein elektrostatisch wirkender Chuck verwendet wird. In diesem Falle könnte auch auf eine Klebe- oder Schutzfolie zwischen Wafer und Chuck verzichtet werden. Ein elektrostatischer Chuck ist ein Chuck, der mittels Ladungen einen Wafer hält. Das Hauptanwendungsgebiet solcher elektrostatischer Chucks liegt in der Waferfertigung im Bereich des Waferhaltens im Vakuum, da dort gerade keine Ansaugung des Wafers möglich ist und mit den bislang üblichen Klemmvorrichtungen stets sehr hohe Defektdichten möglich waren. Mit dem berührungslosen Halten eines Wafers durch Ladungen bei einem elektrostatischen Chuck ist zum Einen eine Reduktion der Defektdichte erreichbar und zum Anderen eine größere Flächennutzung des Wafers möglich, da die Klemmvorrichtungen die Gleichmäßigkeit der Waferoberfläche nicht mehr stört.

Das erfindungsgemäße Verfahren eignet sich besonders vorteilhaft bei der Herstellung sogenannter dünner Wafer, da insbesondere bei dünnen Wafern das Problem des Randflatterns bzw. der Randabbrüche besonders gravierend ist. Unter einem dünnen Wafer ist ein Wafer mit einer Dicke kleiner 140 µm, vorteilhafterweise von kleiner 70 µm, zu verstehen. Das erfindungsgemäße Verfahren eignet sich also insbesondere für sogenannte unstabilisierte Wafer. Unter unstabilisierten Wafern sind solche Wafer zu verstehen, bei denen aufgrund des Verhältnisses von Waferdicke zu Waferdurchmesser eine Planarität der Oberfläche bzw. die erforderliche Steifigkeit des Wafers nicht mehr gewährleistet ist. Unstabilisierten Wafern ist typischerweise das Problem von flatternden Rändern bzw. Randausbrüchen inhärent. Der besondere Vorteil der vorliegenden Erfindung besteht darin, dass auch solche unstabilisierte, dünne Wafer ohne nennenswerte Einschränkung bzw. Umgestaltung der Herstellungstechnologie mittels herkömmlicher Verfahren und Anordnungen weiter bearbeitet werden können. Gleichwohl bleibt festzustellen, dass das erfindungsgemäße Verfahren selbstverständlich auch bei herkömmlichen, d.h. nicht dünn geschliffenen Wafern, vorteilhaft einsetzbar ist.

Weitere vorteilhafte Ausgestaltungen und Weiterbildungen der Erfindung sind in den Untersprüchen sowie der Beschreibung unter Bezugnahme auf die Zeichnung entnehmbar.

Die Erfindung wird nachfolgend anhand der in den Figuren der Zeichnung angegebenen Ausführungsbeispiele näher erläutert. Es zeigt dabei:
- Figur 1: anhand von zwei schematisierten Teilschnitten (a) und (b) ein bisher verwendetes Verfahren zum Dünnen eines Wafers;
- Figur 2: anhand von schematisierten Teilschnitten (a) - (g) das erfindungsgemäße Verfahren zum Dünnen eines Wafers.

In allen Figuren der Zeichnung sind gleiche bzw. funktionsgleiche Elemente - sofern nichts anderes angegeben ist - mit gleichen Bezugszeichen versehen worden.

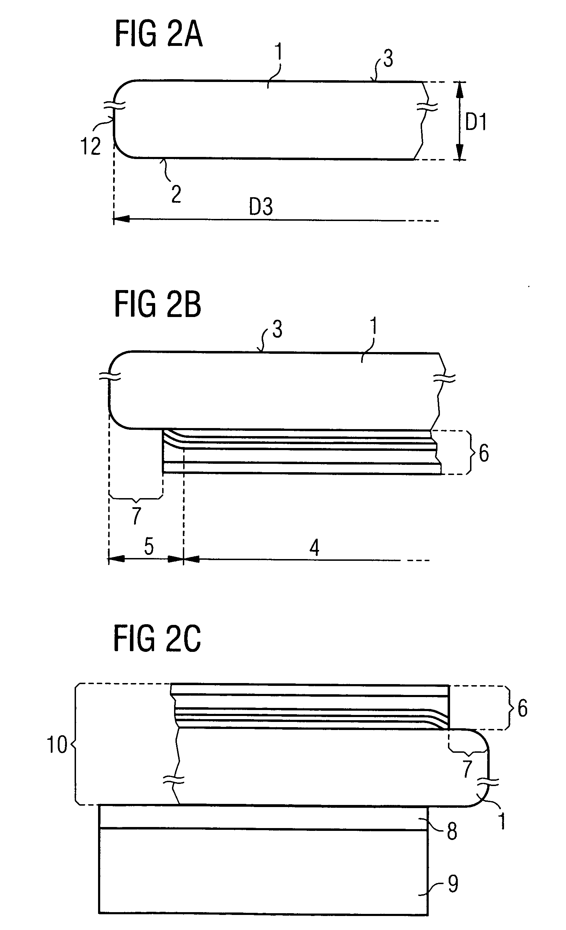

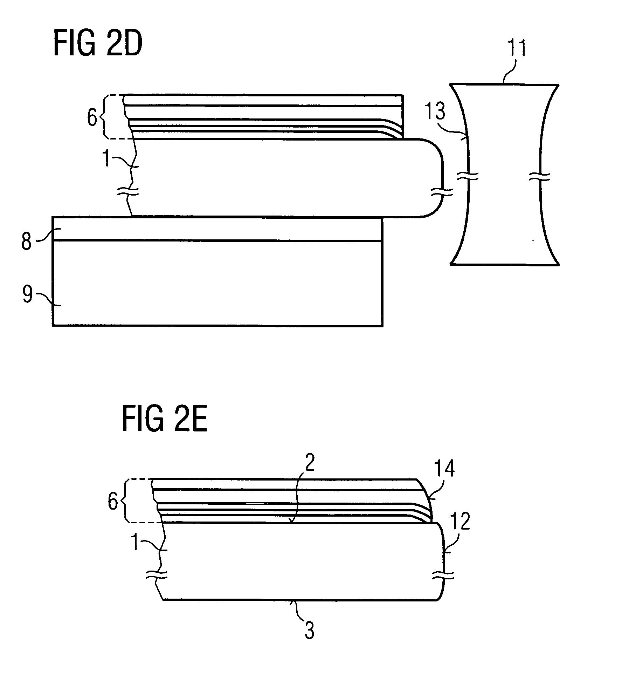

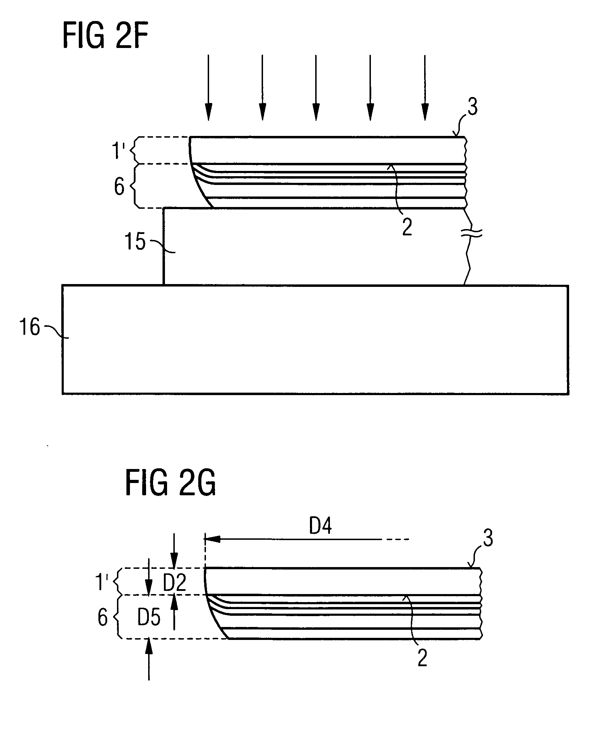

Figur 2 zeigt anhand von Teilschnitten schematisch den erfindungsgemäßen Verfahrensablauf zum Dünnen eines Wafers. Die nachfolgenden Nummerierungen entsprechen jeweils den entsprechenden Teilen der Figur 2:
(a) Ein mit Bezugszeichen 1 bezeichneter Wafer, beispielsweise aus Silizium, wird bereitgestellt. Der Wafer 1 weist eine erste Oberfläche 2, die sogenannte Scheibenvorderseite, und eine zweite Oberfläche 3, die sogenannte Scheibenrückseite, auf.
(b) Der Wafer 1 wird halbleitertechnologisch prozessiert, d.h. es werden im inneren Bereich 4 die für die entsprechenden Halbleiterbauelemente vorgesehenen Strukturen im Halbleiterkörper erzeugt (in Figur 2(b) nicht dargestellt). In einem Randbereich 5 weist der Wafer 1 typischerweise keine Halbleiterbauelemente auf. Zusätzlich werden im inneren Bereich 4 eine oder mehrere Schichten 6 auf die erste Oberfläche 2 aufgebracht. Im vorliegenden Falle wurden insgesamt fünf Schichten 6, die sich durch verschiedene grafische Darstellungen voneinander unterscheiden, dargestellt. Diese Schichten 6 können beispielsweise aus dotiertem oder undotiertem Polysilizium, einem Dielektrikum, beispielsweise Siliziumdioxid (SiO₂) oder Siliziumnitrid (Si₃N₄), einer elektrisch leitfähigen Schicht, beispielsweise ein Metall, ein Metallsilizid, eine Metalllegierung oder dergleichen, bestehen. Die Schichten 6 können durch Aufsputtern, durch Abscheidung oder im Falle von thermischen Siliziumdioxid durch Aufwachsen in sauerstoffhaltiger Atmosphäre bei hoher Temperatur erzeugt werden.
   Die Schichten 6 können je nach verwendeter Technologie mehr oder weniger über den Randbereich 5 überlappen. Aufgrund der eingangs beschriebenen Problematik, d.h. der Notwendigkeit der Verwendung einer Randentlackung, wird zumindest ein Teil des Randbereiches 5 nicht von den Schichten 6 bedeckt. Dieser nicht bedeckte Randbereich ist in Figur 2(b) mit Bezugszeichen 7 bezeichnet.
(c) Auf die Scheibenrückseite 3 des Wafers 1 wird eine Klebeschicht 8, beispielsweise eine beidseitig klebende Folie, ein Klebeband oder ein Kleber, aufgebracht. Die Waferanordnung 10 bestehend aus Wafer 1, Schichten 6 und Klebeschicht 8 wird sodann mit der Klebeschicht 8 auf eine Trägervorrichtung 9, beispielsweise einen Vakuumchuck 9, gelegt. Die Rückseite 3 des Wafers 1 wird anschließend von dem Vakuumchuck 9 angesaugt, wodurch die gesamte Waferanordnung 10 fixiert wird.
(d) Mittels eines um den Randbereich 5 des Wafers 1 umlaufenden Schleifrades 11 wird der Rand abgeschliffen. Damit das Schleifrad 11 ungestört den Randbereich 5 bearbeiten kann, ist es - wie in Figur 2(d) dargestellt - von Vorteil, dass der Chuck 9 einen geringeren Durchmesser als der Wafer 1 aufweist. Durch das Schleifen des Randbereichs 5 wird der nicht bedeckte Randbereich 7 des Wafers 1 abgetragen.
   Der Schleifprozess wird über Drehzahl und Vorschub des Schleifrades 11 sowie über die Körnung der schleifenden Oberfläche 13 des Schleifrades 11 so eingestellt, dass die nicht bedeckten Randbereiche 7 vollständig entfernt werden. Es entsteht somit ein kontinuierlicher Übergang von der Außenfläche 12 am Rand 5 des Wafers 1 zu der Außenfläche 14 der Schichten 6. Eine unerwünschte Stufe zwischen den Schichten 6 und der Scheibenvorderseite 2 wird dadurch vermieden.
   Im vorliegenden Fall weist das Schleifrad 11 eine nach außen gewölbte schleifende Oberfläche 13 auf. Diese in etwa konkav ausgebildete Schleiffläche 13 greift an den Außenflächen 12, 14 an und führt damit zu in etwa konvexen, abgerundeten Außenflächen 12, 14. Um einen solchen kontinuierlicher Übergang der Außenflächen 12, 14 sicherzustellen, ist es erforderlich, dass auch ein geringfügiger Teil der Schicht 6 mit abgetragen wird.
(e) Die Waferanordnung 10 wird vom Chuck 9 genommen. Anschließend wird die Klebeschicht 8 von der Scheibenrückseite abgelöst.
(f) Auf der Seite der Scheibenvorderseite 2 wird eine weitere Klebeschicht 15 auf die Schicht 6 aufgebracht. Die Waferanordnung 10 wird sodann auf einen Vakuumchuck 16, der nicht notwendigerweise einen geringeren Durchmesser als der Wafer 1 aufweisen muss, gelegt und von diesem angesaugt. Anschließend wird der Wafer 1 von der Scheibenrückseite 3 her gedünnt. Das Dünnen des Wafers 1 kann beispielsweise durch Schleifen, Ätzen oder dergleichen erfolgen. Beim Dünnen wird die Dicke des Wafers 1, die ursprünglich eine Dicke D1 im Bereich von 500 - 800 µm aufweist, auf eine geringere Dicke D2 < D1 reduziert. Es entsteht ein dünner Wafer 1'. Nach dem Dünnen wird der dünne Wafer 1' durch die Schicht 6 sowie die Klebeschicht 15 gestützt. Dadurch, dass der dünne Wafer 1' keine unbedeckten Randbereiche 7 mehr aufweist, wird ein Flattern am Rand 5 bzw. Randausbrüche weitestgehend vermieden.
(g) Schließlich kann der dünne Wafer 1' wieder vom Chuck 16 genommen werden und die Klebeschicht 15 abgelöst werden. Der dünne Wafer 1' kann nun weiter prozessiert werden.

Durch die Formgestaltung des Randes 5 geht auch eine Reduzierung des Waferdurchmessers D3 einher, jedoch ist dies unerheblich für die in den Wafern 1 angeordneten Halbleiterbauelemente, da der Abtrag am Rand im Vergleich zum Waferdurchmesser D3 verschwindend gering ist. Der am Rand 5 abgetragene Bereich bewegt sich typischerweise im Bereich von etwa 1 - 2 mm, was bei heute gängigen Waferdurchmessern D3 von 150, 200 bzw. 300 mm nicht weiter ins Gewicht fällt.

Die mit der Randbearbeitung bzw. Randformung einhergehende Reduzierung des Waferdurchmessers D4 kann für die nachfolgenden Prozessschritte, so z.B. Implantation, Bedampfung, Sputtern, Tempern, etc. durch geeignete Modifikation der entsprechenden Fertigungsanlagen kompensiert werden. Hier kann es unter Umständen erforderlich sein, die Halterungen in diesen Fertigungsanlagen, die der Aufnahme der Wafer dienen, so auszulegen, dass sie für Wafer mit geringfügig geringeren Durchmessern D4 ebenfalls ausgelegt sind.

Zusammenfassend kann festgestellt werden, dass durch ein geringfügiges Abtragen des Randes eines Wafers dieser beim nachfolgenden Dünnen auf sehr einfache, jedoch nichts desto trotz sehr effektive Weise vor flatternden Waferrändern und Randausbrüchen bewahrt werden kann.

Die vorliegende Erfindung wurde anhand der vorstehenden Ausführungsbeispielen so dargestellt, um das Prinzip der Erfindung und dessen praktische Anwendung bestmöglichst darzulegen, jedoch lässt sich die Erfindung selbstverständlich bei geeigneter Abwandlung in mannigfaltigen anderen Ausführungsformen realisieren.

### Bezugszeichenliste

- 1: Wafer
- 1': dünner Wafer
- 2: erste Oberfläche, Scheibenvorderseite
- 3: zweite Oberfläche, Scheibenrückseite
- 4: innerer Bereich des Wafers
- 5: Randbereich/Rand des Wafers
- 6: Schichten
- 7: nicht bedeckter Randbereich
- 8: Klebeschicht, klebende Folie
- 9: (Vakuum-)Chuck
- 10: Waferanordnung
- 11: Schleifrad
- 12: Außenfläche am Rand des Wafers
- 13: schleifende Oberfläche des Schleifrades
- 14: Außenfläche der Schicht
- 15: Klebeschicht, klebende Folie
- 16: (Vakuum-)Chuck
- 20: Randflattern des Wafers
- 21: Rand-/Kantenausbruch
- 22: Stufe

- D1, D2: Dicke des Wafers
- D3, D4: Durchmesser des Wafers
- D5: Dicke der Schicht

## Patentansprüche

1. Verfahren zur Formgebung eines Randbereiches (5) eines Wafers (1, 1') mit den Verfahrensschritten:
(a) Ein Wafer (1) mit einer ersten und einer zweiten Oberfläche (2, 3) wird bereitgestellt;
(b) Auf einen inneren Bereich (4) der ersten Oberfläche (2) wird mindestens eine Schicht (6) aufgebracht, so dass zumindest ein Teil (7) eines Randbereiches (5) auf der ersten Oberfläche (2) von der mindestens einen Schicht (6) unbedeckt bleibt;
(c) Der Randbereich (5) des Wafers (1) wird so lange abgetragen, bis sämtliche Randbereiche (5) auf der ersten Oberfläche (2) von der mindestens einen Schicht (6) bedeckt sind;
(d) Der Wafer (1) wird von der zweiten Oberfläche (3) her bis zu einer vorgegebenen Dicke (D2) dünn geschliffen.

2. Verfahren nach Anspruch 1,
**dadurch gekennzeichnet,**
**dass** der Abtrageschritt (c) durch Abschleifen mittels eines um den Randbereich (5) umlaufenden Schleifrades (11) erfolgt.

3. Verfahren nach Anspruch 2,
**dadurch gekennzeichnet,**
**dass** das Schleifrad (11) eine zumindest teilweise konkav ausgebildete Schleifoberfläche (13) aufweist.

4. Verfahren nach einem der vorstehenden Ansprüche,
**dadurch gekennzeichnet,**
**dass** der Randbereich (5) sowie die darauf aufgebrachte mindestens eine Schicht (6) nach dem Abtrageschritt (c) eine durchgehende Außenfläche (12, 14) ausbildet.

5. Verfahren nach einem der vorstehenden Ansprüche,
**dadurch gekennzeichnet,**
**dass** die Randabtragung unter Zuhilfenahme eines Laser mit hoher Laserstrahlleistung erfolgt.

6. Verfahren nach einem der vorstehenden Ansprüche,
**dadurch gekennzeichnet,**
**dass** die Randabtragung unter Zuhilfenahme eines fokussierten Wasserstrahls mit hoher Wasserstrahlgeschwindigkeit erfolgt.

7. Verfahren nach einem der vorstehenden Ansprüche,
**dadurch gekennzeichnet,**
**dass** zur Randabtragung ein Polierfilzmittel mit abtragender Eigenschaft vorgesehen ist.

8. Verfahren nach einem der vorstehenden Ansprüche,
**dadurch gekennzeichnet,**
**dass** der Wafer (1) vor dem Dünnschleifen (d) und/oder vor dem Abtrageprozess (c) auf einen elektrostatischen Chuck (9, 16) gelegt wird.

9. Verfahren nach einem der vorstehenden Ansprüche,
**dadurch gekennzeichnet,**
**dass** der Wafer (1) nach dem Dünnschleifen (d) eine Dicke (D2) von weniger als 140µm, insbesondere von weniger als 70µm, aufweist.
